# EUROPÄISCHE PATENTANMELDUNG

(11) **EP 2 267 739 A1**
(43) Veröffentlichungstag der Anmeldung: **29.12.2010**
(21) Anmeldenummer: 09163700.9
(22) Anmeldetag: 25.06.2009
(51) Int. Cl.: H01H 11/00, H01H 71/04, G01R 31/327, H01H 9/16

(54) **Verfahren zur Überwachung eines Zustands eines Leistungsschalters und Vorrichtung zur Überwachung eines mechanischen Zustands eines Leistungsschalters**

(71) Anmelder: Siemens Aktiengesellschaft, 80333 München (DE)
(72) Erfinder: Döbbeler, Arno, 91074, Herzogenaurach (DE); Rieger, Detlef, 85598, Baldham (DE)

(57) **Zusammenfassung**

Die Erfindung betrifft eine Vorrichtung zur Überwachung eines mechanischen Zustands eines Leistungsschalters (L), insbesondere eines Ofenschalters für einen Lichtbogenofen und ein Verfahren zur Überwachung eines Zustands eines Leistungsschalters (L), insbesondere eines Ofenschalters für einen Lichtbogenofen. Indem ein mit einer technischen Erfassungseinrichtung (1, 2, 3, 4) erfasster mechanischer Zustand des Leistungsschalters (L) und/oder eines mit dem Leistungsschalter (L) kinematisch gekoppelten Bauteils zur Überwachung des Zustands, insbesondere eines elektrischen Zustands, verwendet wird, können überraschende Ausfälle von Leistungsschaltern besser vermieden werden.

## Beschreibung

Die Erfindung betrifft ein Verfahren zur Überwachung eines Zustands eines Leistungsschalters, insbesondere eines Ofenschalters für einen Lichtbogenofen. Ferner betrifft die Erfindung eine Vorrichtung zur Überwachung eines mechanischen Zustands eines Leistungsschalters, insbesondere eines Ofenschalters für einen Lichtbogenofen.

In Industrieanlagen, z.B. Elektrostahlwerke oder Energieversorgungseinrichtungen, werden Leistungsschalter eingesetzt, die derart ausgebildet sind, dass diese auch bei hohen elektrischen Leistungen noch schalten können. Derartige Leistungsschalter sind für hohe Ströme oder hohe Spannungen ausgelegt. In der Regel können diese nicht nur Betriebsströme und geringe Überlastströme schalten, sondern auch bei Fehlern hohe Überlastströme und Kurzschlussströme bewältigen.

Die Funktionsfähigkeit eines derartigen Leistungsschalters ist bei bestimmten Anlagen, z.B. Elektrostahlwerken, Vorraussetzung für deren Betrieb, z.B. für einen Elektrolichtbogenofen.

Lichtbogenöfen zur Elektrostahlerzeugung werden bspw. aus Hoch- und Mittelspannungsnetzen über Ofentransformatoren mit Anschlussspannungen typischerweise zwischen 20 und 36 kV und Betriebsströmen bis 4000 A und mehr versorgt. Lichtbogenöfen werden mehrmals je Schmelze ein- und ausgeschaltet, was über den Leistungsschalter, dem sogenannten Ofenschalter, auf der Primärseite des Ofentransformators erfolgt.

Auch wenn vorzugsweise sogenannte Häufigkeitsschalter als Ofenschalter eingesetzt werden, unterliegt der Leistungsschalter aufgrund der hohen Anzahl an Schaltvorgängen und der mitunter sehr hohen Schaltströme einem Verschleiß. Dieser Verschleiß kann mit der Zeit zu Störungen des Schaltbetriebs des Ofenschalters führen.

Aus diesem Grund ist es wünschenswert, den Zustand eines Leistungsschalters zu kennen, insbesondere vorherzusehen, wann ein Ausfall des Leistungsschalters droht, so dass hierdurch bedingt lange Stillstandzeiten einer Anlage vermieden werden können.

Daher ist es für die Wirtschaftlichkeit einer Anlage von hoher Bedeutung, einen Leistungsschalter rechtzeitig auszutauschen, um keine unvorhergesehenen Anlagenstillstände zu erzeugen.

Im Stand der Technik sind Zustandsüberwachungen bekannt, mit deren Hilfe Maßnahmen ergriffen werden, um bspw. Beschädigungen des Leistungsschalters vermeiden zu können.

So ist aus der Japanischen Offenlegungsschrift JP 09168228 A eine Vorrichtung zur Überwachung eines Zustands eines Stromversorgungssystems bekannt, wobei die Überwachung auf Grundlage eines Differenzstroms und eines berechneten Kompensationsstroms erfolgt. Hierdurch kann ermittelt werden, wann ein "self-end voltage defect" vorliegt.

Aufgabe der vorliegenden Erfindung ist es, ein Verfahren und eine Vorrichtung bereitzustellen, mittels welcher die Zustandsüberwachung eines Leistungsschalters weiter verbessert wird, insbesondere im Hinblick auf eine frühere und sichere Erkennung eines sich anbahnenden Fehlers des Leistungsschalters.

Der verfahrensmäßige Teil der Aufgabe wird gelöst mittels eines Verfahren zur Überwachung eines Zustands eines Leistungsschalters, insbesondere eines Ofenschalters für einen Lichtbogenofen, wobei ein mit einer technischen Erfassungseinrichtung erfasster, vorzugsweise während des Schaltens auftretender, mechanischer Zustand des Leistungsschalters und/oder eines mit dem Leistungsschalter kinematisch gekoppelten Bauteils zur Überwachung des Zustands, insbesondere eines elektrischen Zustands, des Leistungsschalters verwendet wird. Durch die Erfassung eines mechanischen Zustands des Leistungsschalters wird ein neuer Parameterraum zugänglich gemacht, welcher mittels einer technischen Erfassungseinrichtung, insbesondere kontinuierlich, überwacht werden kann. Dadurch kann der Zustand des Leistungsschalters noch besser kontrolliert werden. Unerwünschte mechanische Änderungen der Leistungsschaltereigenschaften, z.B. Materialspannungen, sich lösende Bauteile, das Auftreten von Schwingungen, können auf diese Weise frühzeitig erfasst werden, obwohl diese ggf. zu diesem Zeitpunkt noch keinen merklichen Einfluss auf elektrische Parameter haben. Insbesondere kann bspw. auch eine schlechte Stromführung zwischen verschiedenen Bauteilen des Ofenschalters erkannt werden.

Die Erfassung des mechanischen Zustands kann durch jegliche Mittel erfolgen, welche durch den mechanischen Zustand eines Leistungsschalters beeinflussbar sind, bspw. optische Mittel oder akustische Mittel.

Unter einem kinematisch mit dem Leistungsschalter gekoppelten Bauteil wird ein Bauteil verstanden, dass derart mit dem Leistungsschalter gekoppelt ist, dass wenn eine Bewegung des Leistungsschalters oder eines seines Teile vorliegt, diese Bewegung unmittelbar oder mittelbar auch auf das Bauteil übertragen wird.

In einer vorteilhaften Ausgestaltung des Verfahrens wird ein mechanischer Schwingungszustand des Leistungsschalters und/oder eines mit dem Leistungsschalter kinematisch gekoppelten Bauteils während des Betriebs, insbesondere während des Schaltens, des Leistungsschalters erfasst, wobei der erfasste Schwingungszustand mit einem einen bestimmten Zustand des Leistungsschalters charakterisierenden Referenzschwingungszustand verglichen wird, wobei mittels Vergleich bzw. anhand der Abweichungen zwischen erfasstem Schwingungszustand und Referenzschwingungszustand der aktuelle mechanische Betriebszustand des Leistungsschalters ermittelt wird. Seitens der Erfinder wurde erkannt, dass der Schwingungszustand des Leistungsschalters oder eines mit dem Leistungsschalter kinematisch gekoppelten Bauteils Rückschlüsse auf den mechanischen Zustand des Leistungsschalters ermöglicht, wodurch eine relativ exakte Bestimmung des Zustands des Leistungsschalters möglich ist.

Vorzugsweise wird das Spektrum von Schwingungen des Leistungsschalters sowohl in einem Zeitbereich als auch in einem Frequenzbereich betrachtet. Damit ist eine kontinuierliche und gleichzeitig genaue Überwachung des Leistungsschalters möglich, da das Frequenzspektrum den mechanischen Zustand des Leistungsschalters charakterisiert.

Insbesondere ist es vorteilhaft ein sogenanntes Klangspektrum des Schwingungszustands des Leistungsschalters, insbesondere während des Schaltvorgangs, als charakterisierende Größe für den Schwingungszustand zu ermitteln und dieses mit einem Referenz-Klangspektrum zu vergleichen.

Hierzu wird vorzugsweise ein Frequenzspektrum des Leistungsschalters bzw. Bauteils im Ist-Zustand ermittelt und mit einem Referenz-Frequenzspektrum verglichen, das bspw. einem fehlerfreien Betriebszustand des Leistungsschalters bzw. Bauteils entspricht. Es kann zusätzlich oder alternativ auch ein Referenz-Frequenzspektrum herangezogen werden, das einem anderen, nicht fehlerfreien Betriebszustand des Leistungsschalters entspricht.

Die von dem Referenz-Frequenzspektrum auftretenden Abweichungen des Ist-Frequenzspektrums können bestimmten Störquellen, abhängig von der Abweichung, zugeordnet werden. Somit kann vom Schwingungszustand des Leistungsschalters auf dessen mechanischen Zustand geschlossen werden und ggf. auf seine weitere Lebensdauer, ohne dass elektrische Kenngrößen bereits einen baldigen Defekt des Leistungsschalters andeuten.

Für die Erfassung eines Schwingungszustands eines Leistungsschalters können alle dem Fachmann gängigen Methoden angewendet werden.

In einer besonders vorteilhaften Ausführungsform der Erfindung wird der Schwingungszustand mittels Körperschallwellen erfasst. Dies ist eine besonders zuverlässige Methode zur Detektion eines mechanischen Schwingungszustands.

In einer weiteren Ausgestaltung der Erfindung wird der Schwingungszustand mittels sich in einem Gas, insbesondere Luft, ausbreitenden Schallwellen erfasst.

In einer weiteren Ausführungsform der Erfindung wird der Schwingungszustand mittels elektromagnetischer Wellen erfasst, insbesondere mittels eines Laser-Vibrometers und/oder eines Faser-Bragg-Sensors.

In einer besonders vorteilhaften Ausgestaltung der Erfindung wird der Schwingungszustand einer vom Leistungsschalter umfassten oder kinematisch mit dem Leistungsschalter gekoppelten Schraube, insbesondere einer zur Führung eines elektrischen Stroms vorgesehenen Schraube, erfasst. Die Überwachung des Zustands einer zur Stromführung ausgebildeten Schraube ermöglicht ein frühzeitiges Erkennen von Stromführungsstörungen, bedingt etwa durch eine Schraubenfehlstellung, insbesondere einem lockeren Sitz. Schrauben für Ofenschalter werden häufig bei der Servicierung von Ofenanlagen gelöst und neu befestigt, bspw. um eine Vakuumschaltröhre auszutauschen. Es besteht jedoch keine Sicherheit dahingehend, dass eine Schraube fachgerecht eingebaut wurde. Durch eine Überwachung des mechanischen Zustands der Schraube, z.B. mittels eines Faser-Bragg-Sensors, kann eine Fehlerquelle, z.B. eine unpassende Schraube oder nicht richtig befestigte Schraube, schnell erkannt werden. Dadurch kann der Ofenschalter ggf. vor Zerstörung, bspw. durch im Ofenschalter entstehende Lichtbögen bei Nichterkennen des vorliegenden Fehlers, bewahrt werden. Vorzugsweise erfolgt zusätzlich eine Überwachung mechanischer Spannungen der Schraube. Durch die Kombination derartiger Messungen wird eine fehlerhaft angeordnete Schraube oder sich lösende Schraube rechtzeitig und eindeutig erkannt.

Der vorrichtungsmäßige Teil der Aufgabe wird gelöst durch eine Vorrichtung zur Überwachung eines Zustands eines Leistungsschalters, insbesondere eines Ofenschalters für einen Lichtbogenofen, mit einer Einrichtung zur Erfassung eines mechanischen Zustands des Leistungsschalters und/oder eines mit dem Leistungsschalter kinematisch gekoppelten Bauteils und mit einer Auswerteeinrichtung zum Auswerten des erfassten mechanischen Zustands derart, dass Betriebsstörungen des Leistungsschalters erkannt werden. Die erfindungsgemäße Vorrichtung erlaubt die Umsetzung des erfindungsgemäßen Verfahrens und liefert dadurch analoge Vorteile, wie das Verfahren selbst.

In einer bevorzugten Ausführungsform der Erfindung ist die Erfassungseinrichtung als Einrichtung zur Erfassung eines mechanischen Schwingungszustands ausgebildet und die Auswerteeinrichtung zum Auswerten des erfassten Schwingungszustands im Hinblick auf einen einen bestimmten Zustand des Leistungsschalters charakterisierenden Referenzschwingungszustand ausgestaltet. Die Erfinder haben erkannt, dass insbesondere mechanische Schwingungen einen Betriebszustand des Ofenschalters derart charakterisieren, dass daraus ein Zustand des Leistungsschalters abgeleitet werden kann, insbesondere, ob der Leistungsschalter ordnungsgemäß funktioniert oder nicht.

In einer weiteren vorteilhaften Ausgestaltung der Erfindung ist die Erfassungseinrichtung als Körperschallsensor zur Erfassung von Körperschallschwingungen ausgebildet. Körperschallschwingungen sind durch einen Festkörper propagierende Spannungsdifferenzen. Das Frequenzspektrum der Körperschallschwingungen kann vorteilhaft zur Zustandsdetektion des Leistungsschalters verwendet werden.

Ferner ist es eine vorteilhafte Variante, den Körperschallsensor mit einem Messumformer wirkzuverbinden, welcher die erfassten Körperschallschwingungen in elektromagnetische Welle, insbesondere Licht, umformt. Der Messumformer dient der Verbesserung der Störfestigkeit der Vorrichtung und, im vorliegenden Fall der Messung an der Hochspannungsseite, zur galvanischen Entkopplung der Vorrichtung. Vorzugsweise ist der Messumformer innerhalb eines aus Mu-Metall gebildeten Gehäuses angeordnet. Hierbei handelt es sich in der Regel um eine weichmagnetische Nickel-Eisen-Legierung hoher magnetischer Permeabilität, die der Abschirmung niederfrequenter Magnetfelder dient. Mittels des Messumformers wird vorzugsweise ferner das vom Körperschallsensor detektierte Signal verstärkt und digitalisiert. Im Hinblick auf die Anwendung bei einem Ofenschalter, sollte die Energieversorgung des Messumformers derart ausgestaltet sein, dass eine galvanische Trennung der Hochspannungsseite und der Hochstromseite vorliegt. Vorteilhaft ist es, die in Licht gewandelten Körperschallsignale mittels eines Lichtwellenleiters von dem Messumformer zu der Auswerteeinrichtung zu übertragen, da dieses Verfahren entsprechend robust ist.

Zusätzlich oder alternativ kann die Erfassungseinrichtung als Mikrophon zur Erfassung von von dem Leistungsschalter ausgehenden Luftschallwellen ausgebildet sein. Das Mikrofon wird vorzugsweise an einer Außenwand eines Schaltschranks des Leistungsschalters montiert und erfasst einen mechanischen Zustand, insbesondere Schwingungszustand, über Luftschall. In jedem Fall ist das Mikrophon derart zu platzieren, dass es vom Leistungsschalter ausgehenden Schallwellen erfassen kann. Vorzugsweise ist es nahe am Leistungsschalter angeordnet. Diese Methode ist besonders vorteilhaft, da diese technisch besonders einfach ist und natürliche galvanische Trennung zwischen Mikrofon und Hochspannungsseite vorliegt.

Zusätzlich oder alternativ zu einer anderen Erfassungseinrichtung beliebiger Art, ist die Erfassungseinrichtung vorzugsweise als ein auf Basis elektromagnetischer Wellen, insbesondere Licht, arbeitender EM-Sensor ausgebildet. EM steht hierbei für "Elektro-Magnetisch(er)". Der EM-Sensor detektiert bspw. Licht oder Infrarotwellen. Es kann jedoch ein beliebiger Teil des elektromagnetischen Wellenspektrums verwendet werden, um den Schwingungszustand des Leistungsschalters bzw. eines damit kinematisch gekoppelten Bauteils zu detektieren. EM-Sensoren sind in der Regel technisch einfach umsetzbar. Ferner kann eine Detektion des Schwingungszustands kontaktfrei erfolgen.

Vorteilhaft ist ein EM-Sensor als Faser-Bragg-Sensor ausgebildet. Das Prinzip des Faser-Bragg-Sensors besteht darin, dass bei Bestrahlung des Sensors mit breitbandigem Licht nur eine diskrete Wellenlänge zurückreflektiert wird. Schwingt der Faser-Bragg-Sensor so kommt es zu Dichtevariationen im Sensorkopf, wodurch die zurückflektierte Frequenz variiert. Hieraus lässt sich der mechanische Schwingungszustand des Leistungsschalters bzw. des damit kinematisch gekoppelten Bauteils ermitteln. Vorteil hierbei ist es, das der EM-Sensor besonders platzsparend ausgebildet werden kann und auch auf kleinen Flächen installiert werden kann.

In einer weiteren vorteilhaften Ausgestaltung der Erfindung ist zwischen dem Faser-Bragg-Sensor und dem Teil des Leistungsschalters bzw. Bauteil, von welchem der Schwingungszustand erfasst wird, eine Einheit zur Befestigung des Sensors, insbesondere eine Adapterplatte, angeordnet. Dadurch wird sichergestellt, dass der Sensor einerseits sicher befestigt ist und andererseits der Schwingungszustand zuverlässig erfasst wird.

In einer besonders vorteilhaften Ausgestaltung der Erfindung ist der Faser-Bragg-Sensor derart an einer von dem Leistungsschalter und/oder von dem kinematisch mit dem Leistungsschalter gekoppelten Bauteil umfassten, insbesondere zur Stromführung vorgesehenen, Schraube und/oder in deren Umgebung angeordnet, das mittels diesem ein Schwingungszustand der Schraube und/oder der Schraubenumgebung erfassbar ist. Dadurch kann auf besonders einfache, kostengünstige und zuverlässige Weise eine Überwachung der Schraube erfolgen. Ist diese zur Stromführung ausgebildet, dann kann insbesondere die Stromführung der Schraube mittels des Faser-Bragg-Sensors überwacht werden. Vorzugsweise wird dies kombiniert mit einem Sensor zur Erfassung von mechanischen Spannungen der Schraube und/oder deren Umgebung, z.B. einer Unterlegscheibe der Schraube.

In einer Variante der Erfindung ist der Faser-Bragg-Sensor an einer der Schraube zugeordneten Unterlegscheibe angeordnet. Dies ist eine besonders einfache Möglichkeit die Schraube zu überwachen.

In einer alternativen Variante der Erfindung ist der Faser-Bragg-Sensor an der Schraube angeordnet. Dies erlaubt ebenfalls eine Überwachung bzw. eine Erfassung des Schwingungszustands der Schraube und damit - im Falle einer zur Stromführung vorgesehenen Schraube - eine Überwachung des Stromflusses auf Basis des Schwingungszustands

In einer weiteren vorteilhaften Ausführungsform der Erfindung ist der EM-Sensor als Laser-Vibrometer ausgebildet. Dies ist eine weitere berührungslose bzw. kontaktlose Erfassungsmethode. Dabei wird ein Laserstrahl auf einen Flächenbereich des Leistungsschalters gerichtet, welcher mit einem Reflektor versehen ist. Dieser Reflektor, welcher mit dem Leistungsschalter bzw. Bauteil mechanisch mitschwingt, reflektiert das Laserlicht diffus. Von diesem diffus reflektierten Licht wird eine Dopplerverschiebung zwischen eingestrahltem und reflektiertem Licht ermittelt. Dies geschieht vorzugsweise mittels Interferenz. Die Dopplerverschiebung lässt Rückschlüsse auf den mechanischen Schwingungszustand des Leistungsschalters bzw. des Bauteils zu.

Weitere Vorteile der Erfindung ergeben sich aus nachfolgend erläuterten Ausführungsbeispiel, welche anhand der Figuren schematisch dargestellt sind. Es zeigen:
- FIG 1: eine schematische Darstellung einer ersten Ausführungsform zur Ermittelung eines Zustands eines Leistungsschalters,
- FIG 2: eine schematische Darstellung einer zweiten Ausführungsform zur Ermittelung eines Zustands eines Leistungsschalters,
- FIG 3: eine schematische Darstellung einer dritten Ausführungsform zur Ermittelung eines Zustands eines Leistungsschalters,
- FIG 4: eine schematische Darstellung einer vierten Ausführungsform zur Ermittelung eines Zustands eines Leistungsschalters,
- FIG 5: eine schematische Darstellung einer fünften Ausführungsform zur Ermittelung eines Zustands eines Leistungsschalters, insbesondere einer stromführenden Schraube.

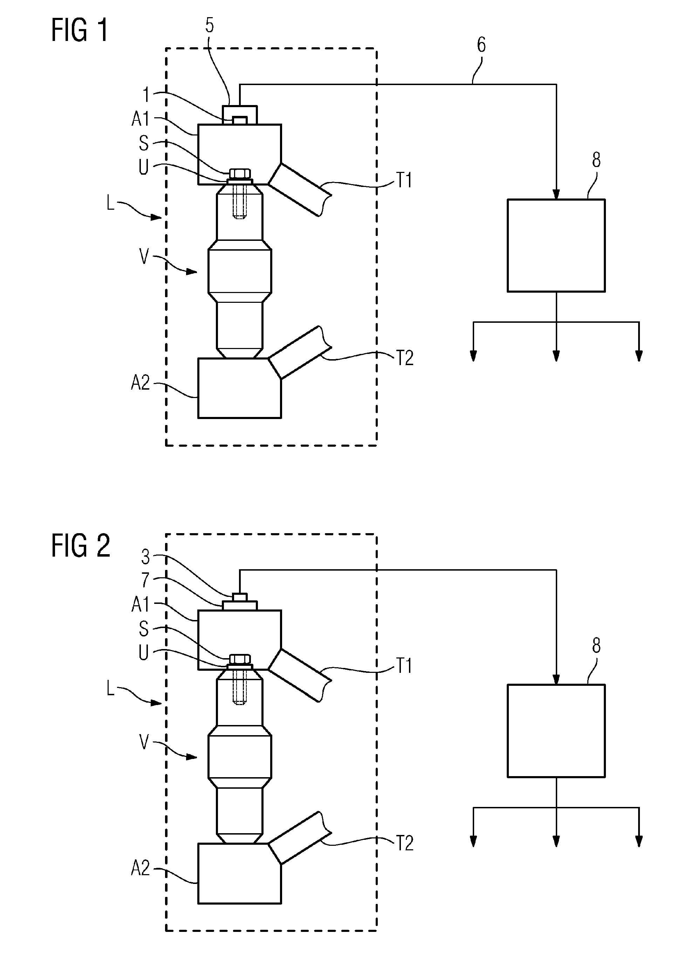

FIG 1 zeigt einen Leistungsschalter L, welcher zum Schalten eines Lichtbogenofens verwendet wird. Der Leistungsschalter L weist mindestens eine Vakuumschaltröhre V auf, welche mit einem ersten Anschlusselement A1 und einem zweiten Anschlusselement A2 verbunden ist. Die Anschlusselemente A1 und A2 dienen der Zu- bzw. Abführung von elektrischer Energie.

Der Leistungsschalter L umfasst im vorliegenden Ausführungsbeispiel ferner einen ersten Stützer T1 und einen zweiten Stützer T2, die jeweils mit einem Anschlusselement A1 bzw. A2 verbunden sind.

Ferner umfasst der Leistungsschalter L einen nicht näher dargestellten Antriebskasten, welcher mit dem ersten und dem zweiten Stützer T1 bzw. T2 verbunden ist.

Im vorliegenden Ausführungsbeispiel ist das erste Anschlussstück A1 mittels einer Schraube S und einer Unterlegscheibe mit der Vakuumschaltröhre V elektrisch leitend verbunden. Beim Schalten fließt also über die Schraube S ein elektrischer Strom, insbesondere im Bereich von mehreren 100 Ampere.

Aufgrund der hohen Ströme und ggf. Spannungen ist sicherzustellen, dass der elektrische Kontakt von Schraube S zu Vakuumschaltröhre V gleichmäßig hoch ist. Bei einem fehlerhaften Einbau der Vakuumschaltröhre in Verbindung mit einer nicht optimal befestigten Schraube und daraus resultierenden schlechten Kontaktbedingungen, kann es zu elektrischen Problemen kommen, bis hin zur Zerstörung des Leistungsschalters L. Dies gilt auch für eine Schraube, die sich im Betrieb lockert.

Diese dargestellte Ausführung eines Leistungsschalters ist beispielhaft. Grundsätzlich kann jeder Leistungsschalter auf die erfindungsgemäße Weise überwacht werden.

Gemäß der Erfindung wird ein mechanischer Zustand des Leistungsschalters L mittels einer technischen Erfassungseinrichtung erfasst und ausgewertet. Eine solche Erfassungseinrichtung kann auf unterschiedliche Art und Weise realisiert werden.

Gemäß FIG 1 ist die Erfassungseinrichtung als Körperschallsensor 1 ausgebildet. Der Körperschallsensor 1 ist gemäß Ausführungsbeispiel der FIG 1 an dem ersten Anschlusselement A1 angeordnet.

Der Körperschallsensor 1 erfasst Körperschallwellen des Leistungsschalters L bzw. eines Teils des Leistungsschalters L. Der Körperschall kann an einer beliebigen schwingfähigen Position des Leistungsschalters L angeordnet werden.

Gemäß FIG 1 ist der Körperschallsensor 1 mit einem Messumformer 5 wirkverbunden, wobei die erfassten Körperschallwellen mittels des Messumformers 5 in Lichtsignale transformiert werden. Diese Lichtsignale werden dann einer Auswerteeinheit 8 zugeführt.

Vorzugsweise wird mittels der Auswerteeinheit 8 aus den erfassten und gewandelten Signalen ein Frequenzspektrum für einen bestimmtes Zeitintervall ermittelt und mit einem Referenzfrequenzspektrum, das für einen fehlerfrei arbeitenden Leistungsschalter derselben Bauart aufgenommen wurde, verglichen. Vorzugsweise ist für eine Vielzahl verschiedener Fehlerfälle des Leistungsschalters ein Referenzschwingungszustand hinterlegt. Dadurch kann der erfasste Schwingungszustand effektiv klassifiziert werden und schnell eine Aussage getroffen werden, in welchem Zustand der Ofenschalter ist.

Anhand der Abweichungen des erfassten Schwingungszustands von einem Referenzschwingungszustand, welcher vorteilhafterweise einen fehlerfreien Betrieb des Leistungsschalters charakterisiert, kann dann eine Aussage getroffen werden, ob der Leistungsschalter noch fehlerfrei arbeitet oder nicht. Ggf. lassen sich aufgrund der Art der Abweichung genauere Aussagen hinsichtlich des vorliegenden Fehlers machen, bspw. ob die das Anschlusselement A1 mit der Vakuumschaltröhre verbindende Schraube S noch so sitzt wie gewünscht. Dies ist vorzugsweise durch Vergleich mit Referenzschwingungszuständen von fehlerhaften Schaltvorgängen möglich. Die Auswertemöglichkeiten sind u.a. davon abhängig, welche und wie viele Referenzschwingungszustände für eine Auswertung hinterlegt sind.

In Abhängigkeit vom Ergebnis der Auswertung können weitere Maßnahmen getroffen werden. Dies ist in FIG 1 durch weitere Pfeile angedeutet, welche von der Auswerteeinheit 8 ausgehen.

Bspw. kann der Betreiber bzw. Bedienpersonal des Elektro-Stahlwerks informiert werden, dass der Ofenschalter, insbesondere der Sitz der Verschraubungen, zu überprüfen ist. Ggf. kann auch eine Service-Mitteilung an den Anlagenbauer bzw. einen Service-Dienstleister ergehen, so dass Service-Personal auf die Anlage geschickt wird, um den Zustand des Ofenschalters L zu prüfen.

FIG 2 zeigt eine alternative Ausgestaltung der Erfassungseinrichtung zur Erfassung eines mechanischen Zustands eines Leistungsschalters L. Hier wird der Schwingungszustand nicht mittels Körperschallsensoren erfasst, sondern mittels eines Faser-Bragg-Sensors 3. Die Funktion eines solchen Sensors 3 wurde bereits im obigen Teil der Beschreibung erläutert. Vorzugsweise wird der Faser-Bragg-Sensor auf eine Adapterplatte 7 geklebt, wodurch einerseits ein möglichst guter Halt und andererseits eine gute Schwingungsübertragung erreicht wird. Die Adapterplatte 7 wiederum ist an einer schwingfähigen Stelle des Leistungsschalters L angeordnet.

Im Übrigen treffen für den Leistungsschalter gemäß FIG 2 die zum Leistungsschalter gemäß FIG 1 gemachten Ausführungen zu. Darüber hinaus gelten die zur Auswertung gemachten Ausführungen im Rahmen der FIG 1 auch für FIG 2.

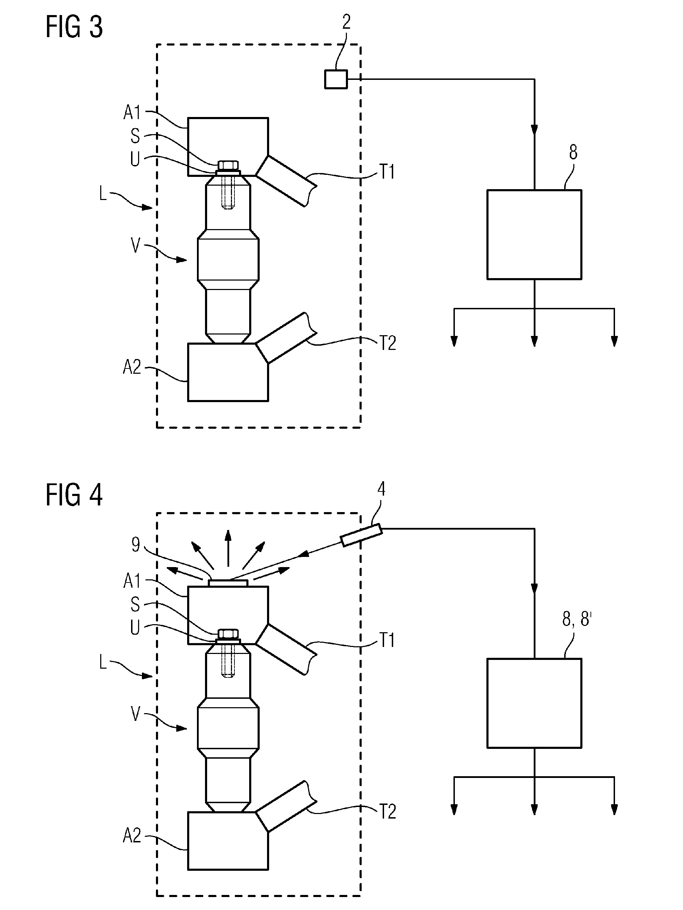

FIG 3 zeigt eine weitere Ausgestaltung der Erfassungseinrichtung zur Erfassung eines mechanischen Zustands eines Leistungsschalters L. Hier wird ein Mikrophon 2 zur Aufnahme von Schallwellen verwendet, welche vom Leistungsschalter L ausgehen. Der Leistungsschalter L gibt aufgrund seiner mechanischen Schwingungen Schallwellen an die Luft ab, welche durch das Mikrophon erfasst werden, in elektrische Signale gewandelt werden und an die Auswerteeinheit 8 weitergeleitet werden. Dort findet dann eine Analyse gemäß obiger Ausführung statt, indem der erfasste Schwingungszustand mit einem Referenzschwingungszustand verglichen wird.

Im Übrigen treffen für den Leistungsschalter gemäß FIG 3 die zum Leistungsschalter gemäß FIG 1 gemachten Ausführungen zu. Darüber hinaus gelten die zur Auswertung gemachten Ausführungen im Rahmen der FIG 1 auch für FIG 3.

FIG 4 zeigt noch eine weitere mögliche Ausführungsform der Erfassungseinrichtung zur Erfassung eines mechanischen Zustands eines Leistungsschalters L. In diesem Fall erfolgt die Erfassung mittels eines Laservibrometers 4. Der Laservibrometer strahlt ein Lichtbündel auf einen am Leistungsschalter L angeordneten Reflektor 9, welcher das eingestrahlte Lichtbündel diffus streut. Da der Reflektor mit dem Leistungsschalter L mitschwingt ergibt sich aufgrund Bewegung des Leistungsschalters eine Frequenzverschiebung im reflektierten, diffus gestreuten Licht. Dieses Licht wird detektiert. Aus den Frequenzverschiebungen des detektierten Lichts relativ zum eingestrahlten Licht lässt sich ein Schwingungszustand für den Leistungsschalter L ableiten, welcher dann für die Auswertung des Zustands des Leistungsschalters L herangezogen wird. Diese Methode erlaubt insbesondere die Messung hoher Schwingungsfrequenzen des Leistungsschalters L. Gemäß FIG 4 ist die Auswerteeinheit 8 und eine Steuereinheit 8' zur Steuerung des Laservibrometers baulich zusammengefasst. Alternativ können diese auch separat ausgestaltet sein.

Im Übrigen treffen für den Leistungsschalter gemäß FIG 4 die zum Leistungsschalter gemäß FIG 1 gemachten Ausführungen zu. Darüber hinaus gelten die zur Auswertung gemachten Ausführungen im Rahmen der FIG 1 auch für FIG 4.

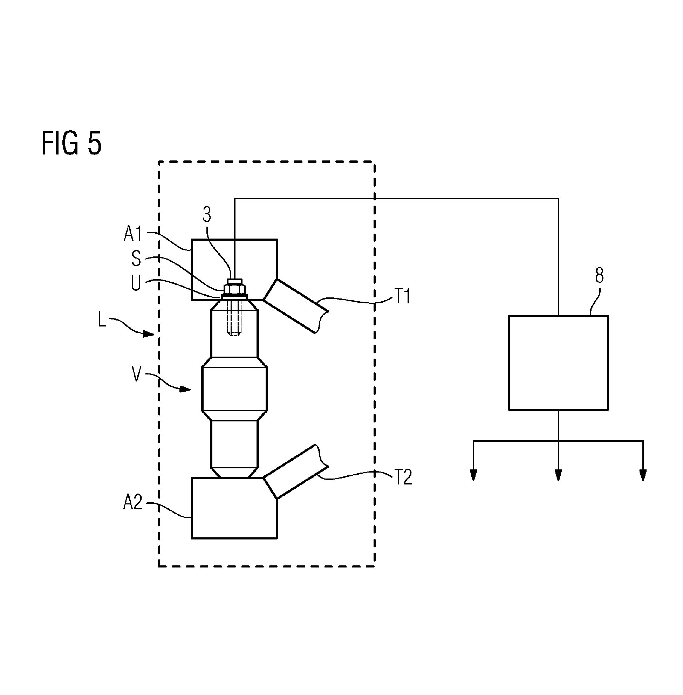

Für die Detektion einer losen Schraube eines Leistungsschalters, insbesondere einer stromführenden Schraube, - dargestellt in FIG 5, kann eine kleinräumige Erfassungseinrichtung genutzt werden, z.B. ein Faser-Bragg-Sensor 3. Gemäß FIG 5 ist dieser direkt auf die Schraube aufgebracht und mit der Auswerteeinheit 8 verbunden. So kann einfach und schnell festgestellt werden, ob die stromführende Schraube in FIG 5 lose ist oder falsch installiert wurde und damit, ob der Betrieb des Leistungsschalters L gefährdet ist.

Vorzugsweise kann zusätzlich eine weitere Messeinrichtung zur Erfassung mechanischer Spannungen an der Schraube S oder deren Umgebung, z.B. an der Unterlegscheibe U, vorgesehen werden. Durch Kombination dieser Messmethoden wird besonders gut erkannt, insbesondere wenn sich mechanische Spannungen ändern, ob eine Schraube lose ist. Alternativ, jedoch nicht dargestellt, kann ein solcher kleinräumiger Sensor, z.B. ein Faser-Bragg-Sensor, anstatt an der Schraube S auch an der Unterlegscheibe U angeordnet sein.

Im Übrigen treffen für den Leistungsschalter gemäß FIG 5 die zum Leistungsschalter gemäß FIG 1 gemachten Ausführungen zu. Darüber hinaus gelten die zur Auswertung gemachten Ausführungen im Rahmen der FIG 1 auch für FIG 5.

## Patentansprüche

1. Verfahren zur Überwachung eines Zustands eines Leistungsschalters (L), insbesondere eines Ofenschalters für einen Lichtbogenofen, **dadurch gekennzeichnet, dass** ein mit einer technischen Erfassungseinrichtung (1, 2, 3, 4) erfasster mechanischer Zustand des Leistungsschalters (L) und/oder eines mit dem Leistungsschalter (L) kinematisch gekoppelten Bauteils zur Überwachung des Zustands, insbesondere eines elektrischen Zustands, verwendet wird.

2. Verfahren nach Anspruch 1,
**dadurch gekennzeichnet, dass** ein mechanischer Schwingungszustand des Leistungsschalters (L) und/oder eines mit dem Leistungsschalter (L) kinematisch gekoppelten Bauteils während des Betriebs des Leistungsschalters (L) erfasst wird, wobei der erfasste Schwingungszustand mit einem einen bestimmten Betriebszustand charakterisierenden Referenzschwingungszustand verglichen wird, wobei mittels eines Vergleichs von erfasstem Schwingungszustand und Referenzschwingungszustand der aktuelle Betriebszustand des Leistungsschalters (L) ermittelt wird.

3. Verfahren nach Anspruch 1 oder 2,
**dadurch gekennzeichnet, dass** der Schwingungszustand mittels Körperschallwellen erfasst wird.

4. Verfahren nach einem der vorhergehenden Ansprüche,
**dadurch gekennzeichnet, dass** der Schwingungszustand mittels sich in einem Gas, insbesondere Luft, ausbreitenden Schallwellen erfasst wird.

5. Verfahren nach einem der vorhergehenden Ansprüche,
**dadurch gekennzeichnet, dass** der Schwingungszustand mittels elektromagnetischer Wellen erfasst wird, insbesondere mittels eines Laser-Vibrometers (4) und/oder eines Faser-Bragg-Sensors (3).

6. Verfahren nach Anspruch 5,
**dadurch gekennzeichnet, dass** der Schwingungszustand einer vom Leistungsschalter (L) umfassten oder kinematisch mit dem Leistungsschalter (L) gekoppelten Schraube (S), insbesondere einer zur Führung eines elektrischen Stroms vorgesehenen Schraube (S), erfasst wird.

7. Vorrichtung zur Überwachung eines Zustands eines Leistungsschalters (L), insbesondere eines Ofenschalters für einen Lichtbogenofen, mit einer Einrichtung (1 ,2 ,3, 4) zur Erfassung eines mechanischen Zustands des Leistungsschalters (L) und/oder eines mit dem Leistungsschalter (L) kinematisch gekoppelten Bauteils und mit einer Auswerteeinrichtung (8) zum Auswerten des erfassten mechanischen Zustands derart, dass ein Betriebszustand, insbesondere Betriebsstörungen, des Leistungsschalters (L) erkannt werden.

8. Vorrichtung nach Anspruch 7,
**dadurch gekennzeichnet, dass** die Erfassungseinrichtung (1, 2, 3, 4) als Einrichtung (1, 2, 3, 4) zur Erfassung eines mechanischen Schwingungszustands ausgebildet ist und die Auswerteeinrichtung (8) zum Auswerten des erfassten Schwingungszustands im Hinblick auf einen einen bestimmten Zustand des Leistungsschalters charakterisierenden Referenzschwingungszustand ausgestaltet ist.

9. Vorrichtung nach Anspruch 7 oder 8,
**dadurch gekennzeichnet, dass** die Erfassungseinrichtung (1, 2, 3, 4) als Körperschallsensor (1) zur Erfassung von Körperschallschwingungen ausgebildet ist.

10. Vorrichtung nach Anspruch 9,
**dadurch gekennzeichnet, dass** der Körperschallsensor (1) mit einem Messumformer (5) wirkverbunden ist, welcher die erfassten Körperschallschwingungen in elektromagnetische Wellen, insbesondere Licht, umformt.

11. Vorrichtung nach Anspruch 10,
**gekennzeichnet durch** einen Lichtwellenleiter (6) zur Übertragung der Lichtwellen von dem Messumformer (5) zu der Auswerteeinrichtung (8).

12. Vorrichtung nach einem der Ansprüche 7 bis 11,
**dadurch gekennzeichnet, dass** die Erfassungseinrichtung (1, 2, 3, 4) als Mikrophon (2) zur Erfassung von Luftschallwellen ausgebildet ist.

13. Vorrichtung nach einem der Ansprüche 7 bis 12,
**dadurch gekennzeichnet, dass** die Erfassungseinrichtung (1, 2, 3, 4) als ein auf Basis elektromagnetischer Wellen, insbesondere Licht, arbeitender EM-Sensor (3, 4) ausgebildet ist.

14. Vorrichtung nach Anspruch1 13,
**dadurch gekennzeichnet, dass** der EM-Sensor (3, 4) als Faser-Bragg-Sensor (3) ausgebildet ist.

15. Vorrichtung nach Anspruch 14,
**dadurch gekennzeichnet, dass** zwischen dem Faser-Bragg-Sensor (3) und dem Teil des Leistungsschalters (L) bzw. Bauteil, von welchem der Schwingungszustand erfasst wird, eine Einheit zur Befestigung des Sensors, insbesondere eine Adapterplatte (7), angeordnet ist.

16. Vorrichtung nach Anspruch 14 oder 15,
**dadurch gekennzeichnet, dass** der Faser-Bragg-Sensor (3) derart an einer von dem Leistungsschalter (L) und/oder von dem kinematisch mit dem Leistungsschalter (L) gekoppelten Bauteil umfassten Schraube (S) und/oder in deren Umgebung angeordnet ist, das mittels diesem ein Schwingungszustand der Schraube (S) und/oder der Schraubenumgebung erfassbar ist.

17. Vorrichtung nach Anspruch 16,
**dadurch gekennzeichnet, dass** der Faser-Bragg-Sensor (3) an einer der Schraube (S) zugeordneten Unterlegscheibe (U) angeordnet ist.

18. Vorrichtung nach Anspruch 16 oder 17,
**dadurch gekennzeichnet, dass** der Faser-Bragg-Sensor (3) an der Schraube (S) angeordnet ist.

19. Vorrichtung nach einem der Ansprüche 7 bis 18,
**dadurch gekennzeichnet, dass** der EM-Sensor (3, 4) als Laser-Vibrometer (4) ausgebildet ist.
